# EUROPEAN PATENT SPECIFICATION

(11) **EP 2 060 926 B1**
(45) Date of publication and mention of the grant of the patent: **02.01.2013**
(21) Application number: 07713899.8
(22) Date of filing: 07.02.2007
(51) Int. Cl.: G01R 33/09

(54) **MAGNETIC SENSOR**
MAGNETSENSOR
CAPTEUR MAGNÉTIQUE

(30) Priority: 26.07.2006 JP 2006203716
(43) Date of publication of application: 20.05.2009
(73) Proprietor: Alps Electric Co., Ltd., Ota-ku Tokyo 145-8501 (JP)
(72) Inventor: SASAKI, Yoshito, Tokyo 145-8501 (JP); SASAKI, Shinichi, Tokyo 145-8501 (JP); SATO, Kiyoshi, Tokyo 145-8501 (JP); HASEGAWA, Naoya, Tokyo 145-8501 (JP); UMETSU, Eiji, Tokyo 145-8501 (JP)
(74) Representative: Klunker . Schmitt-Nilson . Hirsch
(86) International application number: PCT/JP2007/052101
(87) International publication number: WO 2008/012959

(56) References cited:
- JP-A- 2001 345 498
- JP-A- 2003 060 256
- JP-A- 2003 215 222
- JP-A- 2003 533 895
- US-A1- 2003 157 368
- US-A1- 2004 104 724
- US-A1- 2005 200 449

## Description

### Technical Field

The present invention relates to magnetic sensors having a magnetoresistance effect element and, in particular, to a magnetic sensor operating stably in a bipolar fashion regardless of a polarity of an external magnetic field.

### Background Art

A magnetic sensor operating in a contactless fashion employs a Hall element, a magnetoresistance effect element, or the like. A magnetic sensor having a magnetoresistance effect element draws attention because the Hall element consumes high power, needs a hysteresis circuit due to lack of hysteresis, and has difficulty in the miniaturization thereof.

Such a magnetic sensor has been recently used to detect the opening of a flip cellular phone or the like. For example, a magnetoresistance effect element and a fixed resistance element are used and connected in series. A voltage between the elements is output so that on-off changing signals are output in response to a change in the output caused by a change in a magnetic field strength of an external magnetic field. When the flip cellular phone is determined as being opened in response to the output of an on signal, a backlight beneath a display screen or the like is controlled to light.
JP 8017311 A shows a two-wire type magnetic switch circuit using a Hall element. JP 2003060256 A shows a magnetic switch and a magnetic sensor.

### Disclosure of Invention

### Problems to Be Solved by the Invention

However, the above-described opening detection method has the problem described below. Since a change in the resistance of the magnetoresistance effect element depends on the polarity of the external magnetic field, the direction of a magnet placed to face the magnetic sensor is limited. More specifically, if the magnet is placed in a direction opposite to a correct direction, the polarity of the external magnetic field is reversed. The resistance value of the magnetoresistance effect element remains unchanged in response to a change in the magnetic field strength of the external magnetic field having the reversed polarity, and the opening detection fails to operate properly.

US 2005/200449 A1 discloses a magnetic sensor with eight SAF-type GMR elements, in which the magnetization of a pinned layer is pinned in a fixed direction by means of a magnetic field that a permanent bar magnet inserted into a square portion of a yoke of a magnet array generates in the vicinity of a rectangular portion of the yoke. A magnetic field generated in the vicinity of a certain rectangular portion of the yoke differs in direction by 90 degrees from a magnetic field generated in the vicinity of a rectangular portion adjacent to the former rectangular portion.

US 2003/157368 A1 discloses a magnetic field sensor in which magnetoresistance is used as the physical phenomenon for detecting and measuring the magnetic field. The sensor comprises a stack comprising a first ferromagnetic layer, an insulating layer, a second ferromagnetic layer, and an anti-ferromagnetic layer, wherein the two ferromagnetic layers exhibit crossed magnetic anisotropies and form with the insulating layer a tunnel junction.

US 2004/104724 A1 discloses a magnetic sensor with GMR elements, and heating coils serving as heat generating elements.

The present invention is intended to overcome the above-described problem. Thus, it is an object of the present invention to provide a magnetic sensor having a magnetoresistance effect element that operates in a bipolar fashion regardless of the polarity of the external magnetic field.

The afore-mentioned object is solved by the features of the independent claim 1. Further embodiments are defined in the dependent claims 2 to 6.

A magnetic sensor of the present invention includes a series circuit that connects in a serial connection a first magnetoresistance effect element and a second magnetoresistance effect element, each element having a resistance thereof changing in response to a change in a magnetic field strength of an external magnetic field, and outputs a voltage at a junction between the first magnetoresistance effect element and the second magnetoresistance effect element. The first magnetoresistance effect element changes the resistance thereof in response to a change in the magnetic field strength in a positive direction of the external magnetic field while the second magnetoresistance effect element maintains a constant resistance value, the one direction of the external magnetic field being the positive direction and the direction opposite to the one direction being a negative direction. The second magnetoresistance effect element changes the resistance thereof in response to a change in the magnetic field strength in the negative direction of the external magnetic field while the first magnetoresistance effect element maintains a constant resistance value.

In accordance with the present invention, the magnetic sensor operating in a bipolar fashion regardless of the polarity of the external magnetic field is provided. External magnetic field generating means such as a magnet is free from installation restrictions in comparison with the related art, and the assembling of the magnetic sensor is easy.

In accordance with the present invention, an increase and decrease trend in the resistance change of the first magnetoresistance effect element in response to a change in the positive direction in the magnetic field strength and an increase and decrease trend in the resistance change of the second magnetoresistance effect element in response to a change in the negative direction in the magnetic field strength are preferably reversed with respect to a non-magnetic state of the external magnetic field.

With the reverse trends, changes in the voltage at the junction are set to have the same trend regardless of whether the external magnetic field is in the positive direction or the negative direction. More specifically, if the voltage at the junction tends to decrease with the magnetic field strength of the external magnetic field increasing in the positive direction, the voltage at the junction is set to decrease with the magnetic field strength of the external magnetic field increasing in the negative direction. Any circuit modification or any control modification in a controller is not needed even if the direction of the external magnetic field changes.

In accordance with the present invention, a fixed resistance value X1 of the second magnetoresistance effect element with the external magnetic field in the positive direction is larger than a minimum resistance value X2 of the first magnetoresistance effect element changing in response to a change in the magnetic intensity in the positive direction and smaller than a maximum resistance value X3 of the first magnetoresistance effect element changing in response to a change in the magnetic intensity in the positive direction. Preferably, a fixed resistance value X4 of the first magnetoresistance effect element with the external magnetic field in the negative direction is larger than a minimum resistance value X5 of the second magnetoresistance effect element changing in response to a change in the magnetic intensity in the negative direction and smaller than a maximum resistance value X6 of the second magnetoresistance effect element changing in response to a change in the magnetic intensity in the negative direction. Preferably, a ratio of (the fixed resistance value X1 - the minimum resistance value X2: the maximum resistance value X3 - the fixed resistance value X1) is equal to a ratio of (the maximum resistance value X6 - the fixed resistance value X4: the fixed resistance value X4 - the minimum resistance value X5). Preferably, the fixed resistance value X1 is a median value between the minimum resistance value X2 and the maximum resistance value X3, and the fixed resistance value X4 is a median value between the minimum resistance value X5 and the maximum resistance value X6.

With the arrangement, there is provided a timing at which the varying resistance of the first magnetoresistance effect element becomes equal to the fixed resistance value X1 of the second magnetoresistance effect element when the external magnetic field operates in the positive direction. There is also provided a timing at which the varying resistance of the second magnetoresistance effect element becomes equal to the fixed resistance value X4 of the first magnetoresistance effect element when the external magnetic field operates in the negative direction. The voltage at this timing is set to be a threshold value for switching the changing signals. In accordance with the present invention, such an adjustment causes the same timing to be applied regardless of whether the external magnetic field is positive or negative. The magnetic sensor as a bipolar operating magnetic sensor is easily adjusted in threshold voltage without any offset, and operates reliably.

The first magnetoresistance effect element and the second magnetoresistance effect element have preferably the same layer structure composed of an antiferromagnetic layer, a fixed magnetic layer, a nonmagnetic intermediate layer, and a free magnetic layer. In an R-H curve with the abscissa thereof representing the external magnetic field and the ordinate thereof representing the resistance value of the magnetoresistance effect element, a first interlayer coupling magnetic field Hin1 acting on the fixed magnetic layer and the free magnetic layer of the first magnetoresistance effect element is preferably shifted in the positive direction of the external magnetic field, and a second interlayer coupling magnetic field Hin2 acting on the fixed magnetic layer and the free magnetic layer of the second magnetoresistance effect element is preferably shifted in the negative direction of the external magnetic field.

The above-described adjustment causes a so-called hysteresis loop to form in a positive region of the external magnetic field in the first magnetoresistance effect element and a hysteresis loop in a negative region of the external magnetic field in the second magnetoresistance effect element. With this arrangement, the first magnetoresistance effect element changes the resistance thereof in response to a change in the magnetic field strength in the positive direction of the external magnetic field while the second magnetoresistance effect element maintains a constant resistance value, and the second magnetoresistance effect element changes the resistance thereof in response to a change in the magnetic field strength in the negative direction of the external magnetic field while the first magnetoresistance effect element maintains a constant resistance value. The bipolar operating magnetic sensor is easily and appropriately constructed.

In accordance with the present invention, the first interlayer coupling magnetic field Hin1 and the second interlayer coupling magnetic field Hin2 preferably have the same magnitude (in the absolute value).

With this arrangement, the resistance value of the magnetoresistance effect element is changed at the same timing regardless of whether the external magnetic field is positive or negative. The magnetic sensor reliably operates as a bipolar operating magnetic sensor.

With the interlayer coupling magnetic field adjusted as described above, the magnetization of the fixed magnetic layer and the magnetization of the free magnetic layer in one of the first magnetoresistance effect element and the second magnetoresistance effect element are in the same direction in the non-magnetic state of the external magnetic field, the magnetization of the fixed magnetic layer and the magnetization of the free magnetic layer in the other of the first magnetoresistance effect element and the second magnetoresistance effect element are anti-parallel to each other, and the magnetization of the fixed magnetic layer of the first magnetoresistance effect element and the magnetization of fixed magnetic layer of the second magnetoresistance effect element are aligned in the same direction.

In accordance with the present invention, preferably, two first magnetoresistance effect elements and two second magnetoresistance effect elements are arranged, a first serial circuit is formed of one of the first magnetoresistance effect elements and one of the second magnetoresistance effect elements, and a second serial circuit is formed of the remaining first magnetoresistance effect element and the remaining second magnetoresistance effect element. The first magnetoresistance effect element in the first serial circuit and the second magnetoresistance effect element in the second serial circuit are preferably connected in parallel and the second magnetoresistance effect element in the first serial circuit and the first magnetoresistance effect element in the second serial circuit are connected in parallel. A difference between a voltage at a junction of the first serial circuit and a voltage at a junction of the second serial circuit is preferably output as a differential voltage.

With this arrangement, a change in the voltage responsive to a change in the magnetic field strength of the external magnetic field is increased. The magnetic sensor having a high sensitivity thus results.

### Advantages

The present invention provides a bipolar operating magnetic sensor that operates regardless of the polarity of an external magnetic field. A magnet generating an external magnetic field is free from installation restrictions in comparison with the related art, and the assembling of the magnetic sensor is easy.

### Best Mode for Carrying Out the Invention

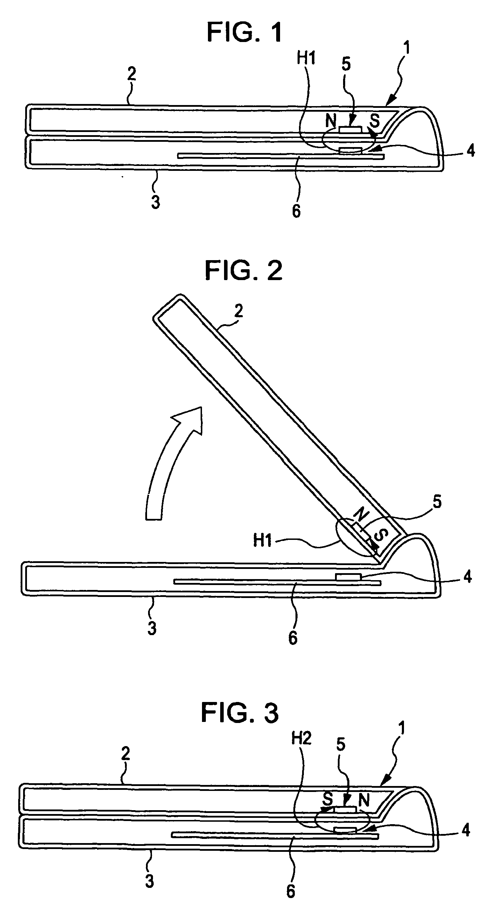

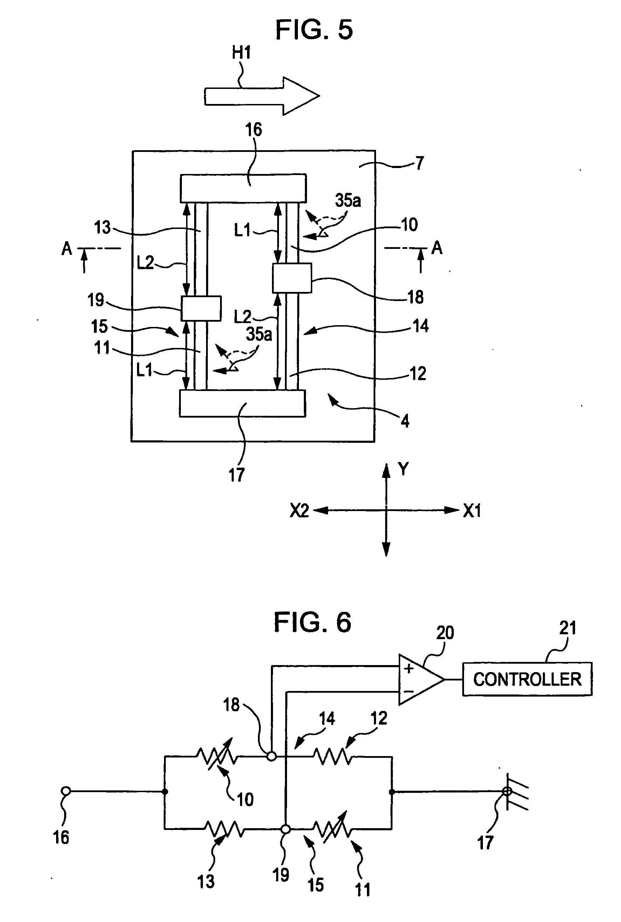

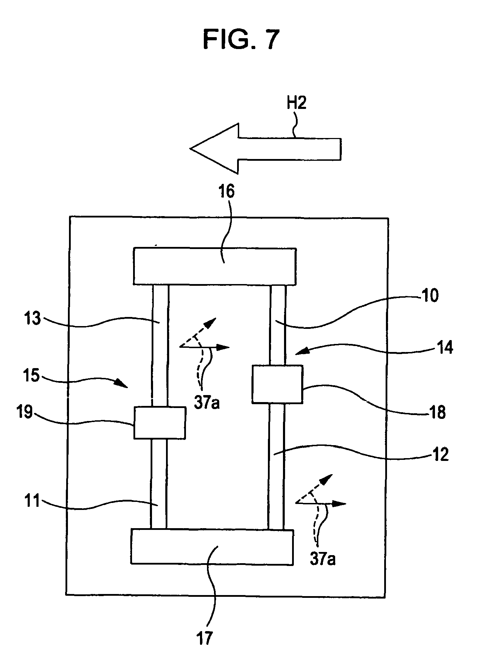

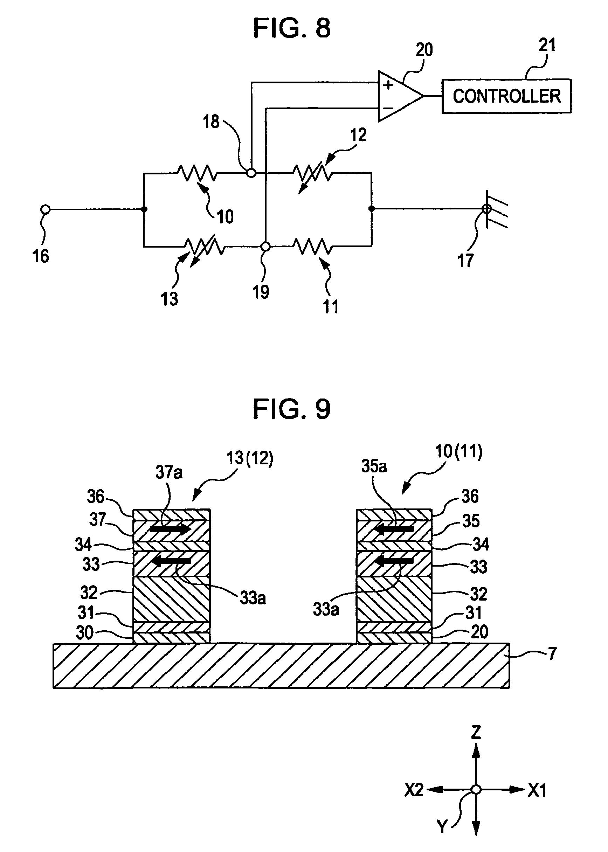

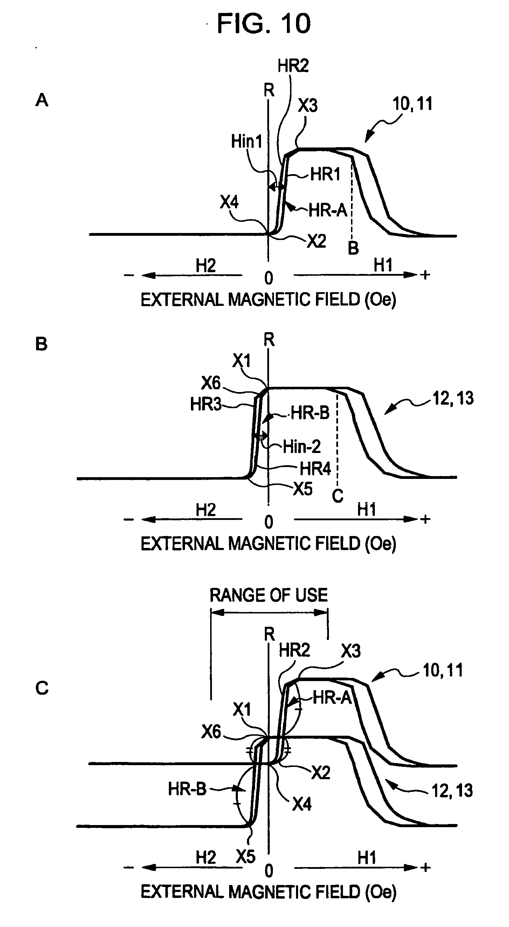

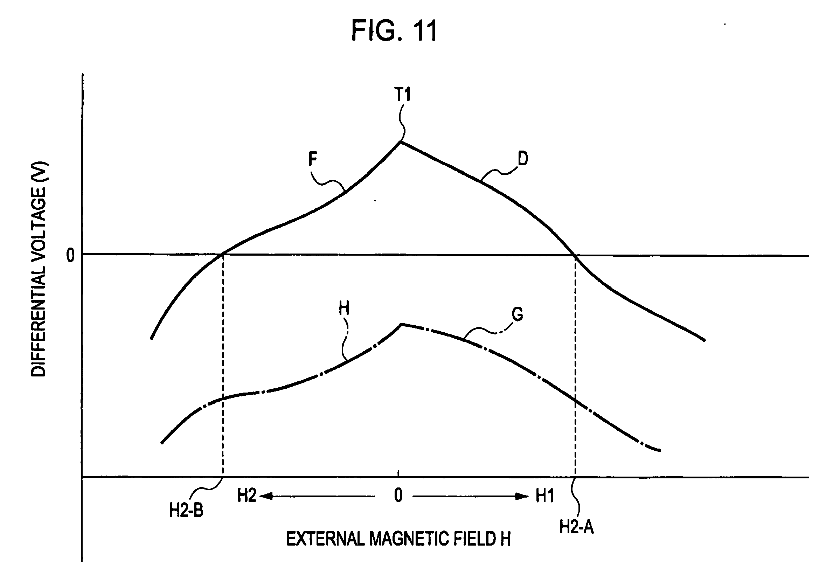

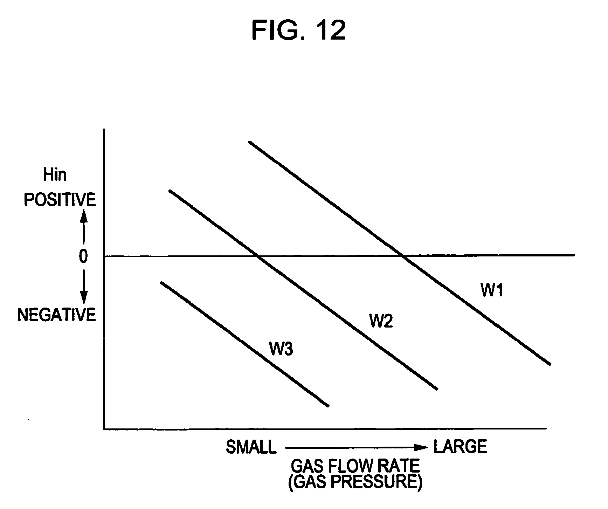

Figs. 1 through 4 are partial diagrammatic views of a flip cellular phone containing a contactless magnetic sensor in accordance with a present embodiment. Figs. 5 and 7 are partial plan views of the contactless magnetic sensor of the present embodiment. Figs. 6 and 8 are circuit diagrams of the magnetic sensor. Fig. 9 is a partial sectional view of the contactless magnetic sensor taken along line A-A and viewed from arrows in Fig. 5. Fig. 10A is a graph (R-H curve) representing hysteresis characteristics of a first magnetoresistance effect element, Fig. 10B is a graph (R-H curve) representing hysteresis characteristics of a second magnetoresistance effect element, and Fig. 10C is a graph (R-H curve) combining the hysteresis characteristics of Figs. 10A and 10B. Fig. 11 is a graph representing a relationship between an external magnetic field and a differential voltage. Fig. 12 is a graph representing a relationship of a gas pressure and a power value during plasma treatment and an interlayer coupling magnetic field Hin.

Referring to Fig. 1, a flip cellular phone 1 includes a first unit 2 and a second unit 3. The first unit 2 is on a display screen side, and the second unit 3 is an operation body side. A liquid-crystal display, a receiver, etc. are arranged on a facing surface of the first unit 2 facing the second unit 3. A variety of buttons, a microphone, etc. are arranged on a facing surface of the first unit 2 facing the second unit 3. Fig. 1 illustrates the flip cellular phone 1 in the closed state thereof. As illustrated in Fig. 1, the first unit 2 includes a magnet 5, and the second unit 3 includes a magnet sensor 4. In the closed state illustrated in Fig. 1, the magnet 5 and the magnet sensor 4 are arranged in mutually facing positions thereof. Alternatively, the magnet sensor 4 may be arranged in a position slightly shifted from the facing position to the magnet 5 in a direction parallel with an incident direction of an external magnetic field H1.

Referring to Fig. 1, the external magnetic field H1 emitted from the magnet 5 reaches the magnet sensor 4. The magnet sensor 4 detects the external magnetic field H1, thereby detecting that the flip cellular phone 1 is in the closed state thereof.

On the other hand, when the flip cellular phone 1 is opened as illustrated in Fig. 2, the external magnetic field H1 reaching the magnet sensor 4 gradually decreases in magnitude as the first unit 2 is spaced apart from the second unit 3. Finally, the external magnetic field H1 reaching the magnet sensor 4 becomes zero. When the magnitude of the external magnetic field H1 reaching the magnet sensor 4 becomes equal to or lower than a predetermined magnitude, it is detected that the flip cellular phone 1 is in an open state. For example, a controller included in the flip cellular phone 1 controls a back light beneath the liquid-crystal display and the operational buttons to flash.

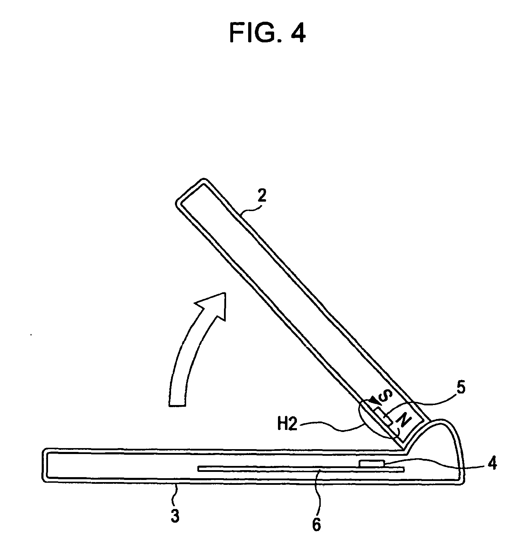

The magnet sensor 4 of the present embodiment is a bipolar operative sensor. More specifically, an N pole of the magnet 5 is placed on the right-hand side and an S pole of the magnet 5 is placed on the left-hand side in Fig. 1. If the polarity is reversed as shown in Fig. 3 (the N pole on the right-hand side and the S pole on the left-hand side), the direction of an external magnetic field H2 reaching the magnet sensor 4 is reversed from the direction of the external magnetic field H1 of Fig. 1. In accordance with the present embodiment, in such a case, the opening of the flip cellular phone 1 is adequately detected when the flip cellular phone 1 is opened as illustrated in Fig. 4 from the closed state of the flip cellular phone 1 illustrated in Fig. 3.

Referring to Fig. 5, the magnet sensor 4 of the present embodiment is mounted on a circuit board 6 to be contained in the second unit 3. The magnet sensor 4 includes two first magnetoresistance effect elements 10 and 11, and two second magnetoresistance effect elements 12 and 13, arranged on one element substrate 7.

Referring to Fig. 5, the magnetoresistance effect elements 10-13 form a bridge circuit. The first magnetoresistance effect element 10 and the second magnetoresistance effect element 12 are connected in a serial connection to form a first serial circuit 14. On the other hand, the first magnetoresistance effect element 11 and the second magnetoresistance effect element 13 are connected in a serial connection to form a second serial circuit 15.

The first magnetoresistance effect element 10 in the first serial circuit 14 and the second magnetoresistance effect element 13 in the second serial circuit 15 are connected in a parallel circuit, and a junction of the two elements serves as an input terminal 16. Also, the second magnetoresistance effect element 12 in the first serial circuit 14 and the first magnetoresistance effect element 11 in the second serial circuit are connected in a parallel connection, and a junction of the two elements serves as a ground terminal 17.

Referring to Fig. 5, a first junction between the first magnetoresistance effect element 10 and the second magnetoresistance effect element 12 in the first serial circuit 14 is a first output terminal 18. A second junction between the first magnetoresistance effect element 11 and the second magnetoresistance effect element 13 in the second serial circuit 15 is a second output terminal 19. The terminals 16-19 are electrically connected to unshown respective terminals on the circuit board 6 through wire bonding or die-bonding.

Referring to Fig. 6, the first output terminal 18 and the second output terminal 19 are connected to a differential amplifier (operational amplifier) 20, and further to a controller 21.

Each of the first magnetoresistance effect elements 10 and 11 and the second magnetoresistance effect elements 12 and 14 has the layer structure described below.

More specifically, referring to Fig. 9, each the first magnetoresistance effect element 10 (11) and the second magnetoresistance effect element 13 (12) includes from the bottom thereof a substrate layer 30, a seed layer 31, an antiferromagnetic layer 32, a fixed magnetic layer 33, a nonmagnetic intermediate layer 34, free magnetic layers 35 and 37 (the free magnetic layer of the second magnetoresistance effect element 13 being designated with the reference number 37), and a protective layer 36 in that order. The substrate layer 30 is made of one non-magnetic material selected from or two or more non-magnetic materials selected from Ta, Hf, Nb, Zr, Ti, and Mo. The seed layer 31 is made of NiFeCr, Cr, or the like. The antiferromagnetic layer 32 is made of an antiferromagnetic material containing an element α (the element α is one element or two or more elements selected from Pt, Ir, Pd, Rh, Ru, and Os) and Mn, or an antiferromagnetic material containing the element α, an element α' (the element α' containing one element or two or more elements selected from Ne, Ar, Kr, Xe, Be, B, C, N, Mg, Al, Si, P, Ti, V, Cr, Fe, Co, Ni, Cu, Zn, Ga, Ge, Zr, Nb, Mo, Ag, Cd, Sn, Hf, Ta, W, Re, Au, Pb, and rare-earth elements), and Mn. For example, the antiferromagnetic layer 32 is made or IrMn or PtMn. The fixed magnetic layer 33, and the free magnetic layers 35 and 37 are made of a magnetic material of a CoFe alloy, an NiFe alloy, a CoFeNi alloy, etc. Also, the nonmagnetic intermediate layer 34 is made of a non-magnetic conductive material such as Cu. To use a tunnel-type magnetoresistance effect element, the nonmagnetic intermediate layer 34 is made of an insulating barrier layer of TiOx or the like. Also, the protective layer 36 is made of Ta or the like. The fixed magnetic layer 33 and the free magnetic layers 35 and 37 have a layered ferri structure (the layered structure of the magnetic layer/nonmagnetic layer/magnetic layer with the two magnetic layers, sandwiching the non-magnetic layer, having magnetizations thereof in anti-parallel directions). The fixed magnetic layer 33 and the free magnetic layers 35 and 37 may have a layered structure made of a plurality of magnetic layers of different materials.

An exchange coupling magnetic field (Hex) is generated between the antiferromagnetic layer 32 and the fixed magnetic layer 33 in each of the first magnetoresistance effect element 10 and the second magnetoresistance effect element 13 because the antiferromagnetic layer 32 and the fixed magnetic layer 33 in direct contact with each other are annealed under a magnetic field, and the magnetization direction of the fixed magnetic layer 33 is fixed to one direction. In Fig. 9, a magnetization direction 33a of the fixed magnetic layer 33 is denoted by an arrow. In each of the first magnetoresistance effect element 10 (11) and the second magnetoresistance effect element 13 (12), the magnetization direction 33a of the fixed magnetic layer 33 is in an X2 direction as shown.

On the other hand, the magnetization direction of the free magnetic layers 35 and 37 is different between the first magnetoresistance effect element 10 and the second magnetoresistance effect element 13. As illustrated in Fig. 7, a magnetization direction 35a of the free magnetic layer 35 in the first magnetoresistance effect element 10 (11) is the X2 direction as shown, and is thus the same direction as the magnetization direction 33a of the fixed magnetic layer 33, but a magnetization direction 37a of the free magnetic layer 37 in the second magnetoresistance effect element 13 (12) is an X1 direction as shown, and is thus anti-parallel to the magnetization direction 33a of the fixed magnetic layer 33.

Referring to Fig. 5, the external magnetic field H1 illustrated in Figs. 1 and 2 impinges on the magnet sensor 4 from the illustrated X2 side to the illustrated X1 direction. The direction of the external magnetic field H1 is referred to as a "positive (plus) direction." On the other hand, referring to Fig. 7, the external magnetic field H2 illustrated in Figs. 3 and 4 impinges on the magnet sensor 4 from the illustrated X1 to the illustrated X2 direction. The direction of the external magnetic field H2 is referred to as a "negative (minus) direction."

If the external magnetic field (positive direction magnetic field) H1 impinges on the magnet sensor 4 as illustrated in Fig. 5, the magnetization direction 35a of the free magnetic layer 35 magnetized in the direction opposite to the direction of the external magnetic field H1 varies, and the resistance values of the first magnetoresistance effect elements 10 and 11 change. Fig. 10A illustrates an R-H curve representing the hysteresis characteristics of the first magnetoresistance effect elements 10 and 11. In the graph, the ordinate represents a resistance value R, but may represent a rate of change of resistance (%). When the external magnetic field H1 gradually increases in the positive direction from non-magnetic field state (zero) as illustrated in Fig. 10A, the resistance value R of the first magnetoresistance effect elements 10 and 11 gradually increases along a curve HR1. The minimum resistance value in the range of the varying resistance value is referred to as X2. On the other hand, the maximum resistance value within the range of the varying resistance value is referred to as X3. When the external magnetic field H1 is gradually decreased from the position of the maximum resistance value X3, the resistance value R of the first magnetoresistance effect elements 10 and 11 gradually decreases along the curve HR2, and then reaches the minimum resistance value X2. In this way, a hysteresis loop (HR-A) defined by the curve HR1 and the curve HR2 is formed in response to the magnetic field strength change in the positive direction of the external magnetic field H1 in the first magnetoresistance effect elements 10 and 11. A median value between the maximum resistance value X3 and the minimum resistance value X2, i.e., a central value of the breadth of the hysteresis loop HR-A is a "center point" of the hysteresis loop HR-A. The strength of the magnetic field from the center point of the hysteresis loop HR-A to the line of the external magnetic field H=0 (Oe) determines the magnitude of a first interlayer coupling magnetic field Hin1. A second interlayer coupling magnetic field Hin2 in Fig. 10B is also determined in the same manner. Also, the breadth of the hysteresis loop HR-A along the center point is equal to twice the coercive force. If the coercive force is too small, problems arises, for example, chattering is likely to occur. The coercive force is preferably larger to some extent. The coercive force is adjusted to 2.5 Oe or so.

Referring to Fig. 10A, the first interlayer coupling magnetic field Hin1 shifts in the positive magnetic field direction in the first magnetoresistance effect elements 10 and 11. If the external magnetic field H1 is increased in the positive direction, the magnetic field strength of the external magnetic field H1 maintains the maximum resistance value X3 up to the position of B. If the external magnetic field H1 is further increased beyond the position of B, even the magnetization direction 33a of the fixed magnetic layer 33 becomes aligned with the direction of the external magnetic field H1. The magnetization direction 33a starts to orient in the same direction together with the magnetization direction 35a of the free magnetic layer 35. The resistance value R of the first magnetoresistance effect elements 10 and 11 gradually decreases, but in practice, the magnet 5 having a magnetic field strength greater than B is not used.

If the external magnetic field H2 is applied in the negative direction as shown in Fig. 7, the free magnetic layer 35 is not varied in response to a change in the magnetic field strength in the negative direction of the external magnetic field H2 because the direction of the external magnetic field H2 is aligned with the direction of the magnetization direction 35a of the free magnetic layer 35 at non-magnetic field state (no external magnetic field) in the first magnetoresistance effect elements 10 and 11. The magnetization direction 35a of the free magnetic layer 35 and the magnetization direction 33a of the fixed magnetic layer 33 are thus maintained in a parallel state. As a result, the resistance value R of the first magnetoresistance effect elements 10 and 11 maintains a constant resistance value (fixed resistance value) X4 in the negative direction external magnetic field H2 as illustrated in Fig. 10A.

The hysteresis characteristics of the second magnetoresistance effect elements 12 and 13 are described below.

When the external magnetic field (the positive direction magnetic field) H1 impinges on the magnet sensor 4 as illustrated in Fig. 5, the magnetization direction 37a of the free magnetic layer 37 magnetized in the same direction as the external magnetic field H1 remains unchanged. Even if the external magnetic field H as the external magnetic field H1 increases from the position of zero as illustrated in Fig. 10B, the second magnetoresistance effect elements 12 and 13 maintain a constant resistant value (fixed resistance value) X1. However, if the magnetic field strength of the external magnetic field H1 increases beyond the position of C and becomes too large, the magnetization direction 33a of the fixed magnetic layer 33 of the second magnetoresistance effect elements 12 and 13 is reversed to the direction of the external magnetic field H1, and the resistance value R of the second magnetoresistance effect elements 12 and 13 thus starts decreasing. In the same manner as described with reference to Fig. 10A, the magnet 5 causing the external magnetic field H1 to be larger than a magnetic field strength C is not used in practice.

When the external magnetic field H2 impinges in the negative direction as illustrated in Fig. 7, the direction of the external magnetic field H2 and the magnetization direction 37a of the free magnetic layer 37 at the non-magnetic field state (zero external magnetic field) of the second magnetoresistance effect elements 12 and 13 are anti-parallel to each other. The magnetization direction 37a of the free magnetic layer 37 is affected by the external magnetic field H2 in the negative direction and is thus varied. Since the magnetization direction 33a of the fixed magnetic layer 33 of the second magnetoresistance effect elements 12 and 13 is anti-parallel to the magnetization direction 37a of the free magnetic layer 37 with the external magnetic field H at non-magnetic field state as illustrated in Fig. 9, the resistance value R becomes high. When the magnetization direction 37a of the free magnetic layer 37 starts to reverse with the external magnetic field H2 in the negative direction (absolute value) gradually increasing, the magnetization direction 37a of the free magnetic layer 37 becomes closer to the magnetization direction 33a of the fixed magnetic layer 33. The resistance value R of the second magnetoresistance effect elements 12 and 13 gradually decreases along the curve HR3. The minimum resistance value within the range of varying resistance value R is referred to X5. On the other hand, the maximum resistance value within the range of varying resistance value R is referred to as X6. When the external magnetic field H2 in the negative direction (absolute value) is decreased from the position of the minimum resistance value X5 (i.e., the external magnetic field H2 becomes closer to zero), the resistance value R of the second magnetoresistance effect elements 12 and 13 gradually increases along the curve HR4 and then reaches the maximum resistance value X6. The hysteresis loop HR-B defined by the curves HR3 and HR4 is thus created.

The second interlayer coupling magnetic field Hin2 of the second magnetoresistance effect elements 12 and 13 is shifted in the negative direction as illustrated in Fig. 10B.

In accordance with the present embodiment, the first interlayer coupling magnetic field Hin1 of the first magnetoresistance effect elements 10 and 11 is shifted in the positive direction of the external magnetic field while the second interlayer coupling magnetic field Hin2 of the second magnetoresistance effect elements 12 and 13 is shifted in the negative direction of the external magnetic field. With the different shift directions, the bipolar operating magnet sensor 4 results.

The principle of the magnet sensor 4 is described with reference to Fig. 10C. Fig. 10C illustrates the hysteresis characteristics of the first magnetoresistance effect elements 10 and 11 illustrated in Fig. 10A and the hysteresis characteristics of the second magnetoresistance effect elements 12 and 13 illustrated in Fig. 10B, plotted on the same R-H curve.

Now, the case in which the magnetic field strength of the external magnetic field varies within a "range of use" as illustrated in Fig. 10C is considered.

First, if the external magnetic field is gradually increased in the positive direction of the external magnetic field H1 from the non-magnetic field state (zero position) as illustrated in Fig. 10C, the resistance value R of the first magnetoresistance effect elements 10 and 11 changes at the position of the hysteresis loop (HR-A). On the other hand, the second magnetoresistance effect elements 12 and 13 maintain a constant resistance value (fixed resistance value) X1 in response to the strength change of the external magnetic field H1 in the positive direction with the resistance of the first magnetoresistance effect elements 10 and 11 changing. More specifically, the second magnetoresistance effect elements 12 and 13 function as a fixed resistance element in response to the positive direction external magnetic field H1. Therefore, as illustrated in the circuit diagram of Fig. 6, the first magnetoresistance effect elements 10 and 11 function as an element that changes the resistance thereof in response to the strength change of the external magnetic field H1 in the positive direction while the second magnetoresistance effect elements 12 and 13 maintain a constant resistance value X1 as a fixed resistor. Therefore, if a magnetic field strength change takes place in the external magnetic field H1 in the positive direction, a voltage value of the first output terminal 18 in the first serial circuit 14 changes and a voltage value of the second output terminal 19 in the second serial circuit 15 also changes.

On the other hand, if the external magnetic field H is gradually increased in the negative direction of the external magnetic field H2 (absolute value) from the non-magnetic field state (zero position) as illustrated in Fig. 10C, the resistance value R of the second magnetoresistance effect elements 12 and 13 changes at the position of the hysteresis loop (HR-B). On the other hand, the first magnetoresistance effect elements 10 and 11 maintain a constant resistance value (fixed resistance value) X4 in response to the strength change of the external magnetic field H2 in the negative direction with the resistance of the second magnetoresistance effect elements 12 and 13 changing. More specifically, the first magnetoresistance effect elements 10 and 11 function as a fixed resistance element in response to the negative direction external magnetic field H2. Therefore, as illustrated in the circuit diagram of Fig. 8, the second magnetoresistance effect elements 12 and 13 function as an element that changes the resistance thereof in response to the strength change of the external magnetic field H2 in the negative direction while the first magnetoresistance effect elements 10 and 11 maintain a constant resistance value X4 as a fixed resistor. Therefore, if a magnetic field strength change takes place in the external magnetic field H2 in the negative direction, a voltage value of the first output terminal 18 in the first serial circuit 14 changes and a voltage value of the second output terminal 19 in the second serial circuit 15 also changes.

As described above, the present embodiment allow the magnet sensor 4 to provide the output in response to the external magnetic field in each of the positive direction and the negative direction. The magnet sensor 4 thus operates in a bipolar fashion. Therefore, the magnet sensor 4 works regardless of whether the magnet 5 causing the external magnetic fields H1 and H2 is oriented in one direction as illustrated in Figs. 1 and 2 or in an opposite direction, namely, as illustrated in Figs. 3 and 4. The way the magnet 5 is installed is not restricted as in the related art, and the assembling of the magnet sensor 4 and the magnet 5 is easy.

In accordance with the present embodiment, the first interlayer coupling magnetic field Hin1 shifts in the positive direction in the first magnetoresistance effect elements 10 and 11 as illustrated in Fig. 10A, and the second interlayer coupling magnetic field Hin2 shifts in the negative direction the second magnetoresistance effect elements 12 and 13 as illustrated in Fig. 10B. In accordance with the present embodiment, in the first magnetoresistance effect elements 10 and 11 as illustrated in Fig. 9, the magnetizations 33a and 35a of the fixed magnetic layer 33 and the free magnetic layer 35 are parallel to each other and are oriented from X1 to X2 direction, i.e., in the same direction as the negative direction of the external magnetic field H2. On the other hand, in the second magnetoresistance effect elements 12 and 13, the magnetizations 33a and 37a of the fixed magnetic layer 33 and the free magnetic layer 37 are anti-parallel to each other, the magnetization direction 33a of the fixed magnetic layer 33 is oriented in the same direction as the magnetization direction 33a of the fixed magnetic layer 33 in the first magnetoresistance effect elements 10 and 11, and the magnetization direction 37a of the free magnetic layer 37 is oriented in the direction from X2 to X1, i.e., in the same direction as the external magnetic field H1 in the positive direction.

In order to obtain the magnetization state of Fig. 9, for example, from the interlayer coupling magnetic fields Hin1 and Hin2 having the mutually opposite signs discussed with reference to Figs. 10A and 10B, a gas flow rate (gas pressure) and a power value during plasma treatment of the surface the nonmagnetic intermediate layer 34, for example, are adequately adjusted.

It is known that the first interlayer coupling magnetic field Hin1 changes in accordance with the magnitude of the gas flow rate (gas pressure) and the magnitude of the power value as illustrated Fig. 12. The magnitudes of power shown in Fig. 12 are W1>W2>W3, and fall within the range of 100 W - 300 W. Referring to Fig. 12, the larger the magnitude of each of the gas flow rate (gas pressure) and the power value, the more the interlayer coupling magnetic field Hin is shifted from the positive value to the negative value. Therefore, the gas flow rate and the power value in the plasma treatment on the second magnetoresistance effect elements 12 and 13 and the gas flow rate and the power value in the plasma treatment on the first magnetoresistance effect elements 10 and 11 are adequately adjusted. With adequate adjustment, the first interlayer coupling magnetic field Hin1 of the first magnetoresistance effect elements 10 and 11 can be shifted in the positive direction and the second interlayer coupling magnetic field Hin2 of the second magnetoresistance effect elements 12 and 13 can be shifted in the negative direction.

Also, the magnitude of the interlayer coupling magnetic field Hin changes in response to a thickness of the nonmagnetic intermediate layer 34.

Also, the magnitude of the interlayer coupling magnetic field Hin can be adjusted by changing the thickness of the antiferromagnetic layer if the antiferromagnetic layer / the fixed magnetic layer / the non-magnetic intermediate layer /the free magnetic layer are laminated in that order from below.

The first interlayer coupling magnetic field Hin1 has a positive value in the first magnetoresistance effect elements 10 and 11, and in such a case, an interaction takes place between the fixed magnetic layer 33 and the free magnetic layer 35 in order to make the magnetizations thereof mutually parallel to each other. Also, the second interlayer coupling magnetic field Hin2 has a negative value in the second magnetoresistance effect elements 12 and 13, and in such a case, an interaction takes place between the fixed magnetic layer 33 and the free magnetic layer 37 in order to make the magnetizations thereof mutually anti-parallel to each other. By causing the exchange coupling magnetic field (Hex) in the same direction between the antiferromagnetic layer 32 and the fixed magnetic layer 33 in each of the magnetoresistance effect elements 10-13 in an annealing process under magnetic field, the magnetization 33a of the fixed magnetic layer 33 in each of the magnetoresistance effect elements 10-13 is fixed to the same direction. The above-described interaction takes place between the fixed magnetic layer 33 and the free magnetic layers 35 and 37, causing the magnetization state illustrated in Fig. 9.

In accordance with the present embodiment, an increase and decrease trend of the resistance value of the first magnetoresistance effect elements 10 and 11 in response to the magnetic field strength change of the external magnetic field H1 in the positive direction and an increase and decrease trend of the resistance value of the second magnetoresistance effect elements 12 and 13 in response to the magnetic field strength change of the external magnetic field H2 in the negative direction tend to reverse to each other with respect to the non-magnetic field state of the external magnetic field H. More specifically, the resistance value R tends to increase gradually in the first magnetoresistance effect elements 10 and 11 as the external magnetic field H1 increases from the non-magnetic field state to the positive direction. On the other hand, the resistance value R tends to decrease gradually in the second magnetoresistance effect elements 12 and 13 as the external magnetic field H2 increases from the non-magnetic field state to the negative direction (absolute value).

For this reason, when the external magnetic field H1 gradually increases in the positive direction, the voltage at the first output terminal 18 illustrated in Fig. 6 gradually falls while the voltage at the second output terminal 19 illustrated in Fig. 6 gradually rises. Similarly, when the external magnetic field H2 (absolute value) gradually increases in the negative direction, the voltage at the first output terminal 18 illustrated in Fig. 8 gradually falls while the voltage at the second output terminal 19 illustrated in Fig. 8 gradually rises. The change of the voltage takes with the same trend regardless of whether the external magnetic field is in the positive direction or the negative direction. By arranging simply a typical bridge circuit illustrated in Figs. 6 and 8, the controller 21 can do the same control process regardless of whether the external magnetic field is in the positive direction or the negative direction. Any circuit modification, any control method modification, or any other modification is not needed regardless of the polarity of the external magnetic field.

In accordance with the present embodiment, the element length of the first magnetoresistance effect elements 10 and 11 is L1 and the element length of the second magnetoresistance effect elements 12 and 13 is L2 as illustrated in Fig. 5. The element length dimension L1 is smaller than the element length dimension L2. When the external magnetic field H is in the non-magnetic field state (zero) as illustrated in Fig. 10C, the resistance value R of the first magnetoresistance effect elements 10 and 11 is smaller than the resistance value R of the second magnetoresistance effect elements 12 and 13. The element resistance can be changed by modifying cross-sectional area, material, and structure of layers. However, the cross-sectional area, the material and the structure of the layers are preferably unchanged with a view to performing a simple manufacturing process and controlling variations in temperature coefficient (TCR). For this reason, the thickness of each layer and the materials illustrated in Fig. 9 are set to be the same between the first magnetoresistance effect elements 10 and 11 and the second magnetoresistance effect elements 12 and 13. However, in order to vary the interlayer coupling magnetic field Hin, the nonmagnetic intermediate layer 34 can be modified in thickness. Also, the layer structure remains the same between the first magnetoresistance effect elements 10 and 11 and the second magnetoresistance effect elements 12 and 13. For example, if the fixed magnetic layer 33 in the first magnetoresistance effect elements 10 and 11 has a synthetic ferri structure, the fixed magnetic layer 33 in the second magnetoresistance effect elements 12 and 13 has also a synthetic ferri structure.

In accordance with the present embodiment, the manufacturing method of the magnet sensor 4 is simple. It suffices if the condition of plasma treatment to the nonmagnetic intermediate layer 34 is changed. At least the first magnetoresistance effect elements 10 and 11 and the second magnetoresistance effect elements 12 and 13 are manufactured on the same process steps up to the nonmagnetic intermediate layer 34. Furthermore, the fixed magnetic layer 33 in the first magnetoresistance effect elements 10 and 11 and the fixed magnetic layer 33 in the second magnetoresistance effect elements 12 and 13 are fixed to the same magnetization direction 33a. The magnetic field directions in the magnetic field annealing process are set to be the same. The magnetic field annealing process is thus concurrently performed on the first magnetoresistance effect elements 10 and 11 and the second magnetoresistance effect elements 12 and 13.

Also, referring to Fig. 10C, the fixed resistance value X1 in the second magnetoresistance effect elements 12 and 13 with the positive direction external magnetic field H1 operating is larger than the minimum resistance value X2 of and smaller than the maximum resistance value X3 of the first magnetoresistance effect elements 10 and 11 changing in response to the magnetic field strength change in the positive direction. Also, the fixed resistance value X4 of the first magnetoresistance effect elements 10 and 11 with the negative direction external magnetic field H2 operating is larger than the minimum resistance value X5 of and smaller than the maximum resistance value X6 of the second magnetoresistance effect elements 12 and 13 changing in response to the magnetic field strength change in the negative direction. As illustrated in Fig. 10C, a ratio of (the fixed resistance value X1 - the minimum resistance value X2: the maximum resistance value X3 - the fixed resistance value X1) is equal to a ratio of (the maximum resistance value X6 - the fixed resistance value X4: the fixed resistance value X4 - the minimum resistance value X5).

Furthermore, in accordance with the present embodiment, the magnitude of the first interlayer coupling magnetic field Hin1 equals the magnitude of the second interlayer coupling magnetic field Hin2 (absolute value).

In accordance with the present embodiment, the first output terminals 18 and 19 are connected to the operational amplifier 20 as illustrated in Figs. 6 and 8, and the relationship between the differential voltage from the operational amplifier 20 and the external magnetic field H are represented by curves D and F in Fig. 11.

Referring to Fig. 11, the differential voltage is T1 with the external magnetic field H at the non-magnetic field state (zero), and T1 is a positive value (T1 is here the positive value although T1 may be set to be a negative value under the control of the operational amplifier 20). With the external magnetic field H1 gradually increasing in the positive direction, the resistance value R of the first magnetoresistance effect elements 10 and 11 rises as previously discussed with reference to Fig. 10C, but the second magnetoresistance effect elements 12 and 13 function as a fixed resistor. As represented by the curve D in Fig. 11, the differential voltage starts to fall gradually. In accordance with the present embodiment, the fixed resistance value X1 of the second magnetoresistance effect elements 12 and 13 is between the minimum resistance value X2 and the maximum resistance value X3 of the first magnetoresistance effect elements 10 and 11. When the external magnetic field H1 increases to H1-A (see Fig. 11), the resistance value R of the first magnetoresistance effect elements 10 and 11 becomes equal to the fixed resistance value X1 of the second magnetoresistance effect elements 12 and 13, and the differential voltage becomes zero.

When the external magnetic field H2 gradually increases in the negative direction (absolute value), the resistance value R of the second magnetoresistance effect elements 12 and 13 decreases as illustrated in Fig. 10C. The first magnetoresistance effect elements 10 and 11 function as a fixed resistor, and the differential voltage starts to fall gradually as represented by the curve F in Fig. 11. In accordance with the present embodiment, the fixed resistance value X4 of the first magnetoresistance effect elements 10 and 11 is between the minimum resistance value X5 and the maximum resistance value X6 of the second magnetoresistance effect elements 12 and 13. When the external magnetic field H2 increases to H2-B (see Fig. 11), the resistance value R of the second magnetoresistance effect elements 12 and 13 becomes equal to the fixed resistance value X4 of the first magnetoresistance effect elements 10 and 11 and the differential voltage becomes zero.

In accordance with the present embodiment, there is a provided a timing at which the differential voltage becomes zero with the varying resistance value R of the first magnetoresistance effect elements 10 and 11 becoming equal to the fixed resistance value X1 of the second magnetoresistance effect elements 12 and 13 while the positive direction external magnetic field H1 is operating. Similarly, there is provided a timing at which the differential voltage becomes zero with the varying resistance value R of the second magnetoresistance effect elements 12 and 13 becoming equal to the fixed resistance value X4 of the first magnetoresistance effect elements 10 and 11 while the negative direction external magnetic field H2 is operating. The voltage at this timing is a threshold voltage. The controller 21 includes a comparator that compares the threshold voltage with a differential voltage that varies every second during use. When the differential voltage becomes equal to the threshold voltage, namely, when the differential voltage becomes zero, the controller 21 switches on-off signals.

In accordance with the present embodiment, the ratio of (the fixed resistance value X1 - the minimum resistance value X2: the maximum resistance value X3 - the fixed resistance value X1) is equal to the ratio of (the maximum resistance value X6 - the fixed resistance value X4: the fixed resistance value X4 - the minimum resistance value X5). Furthermore, since the first interlayer coupling magnetic field Hin1 and the second interlayer coupling magnetic field Hin2 have the same magnitude (absolute value), the magnitude H1-A of the positive direction external magnetic field H1 and the magnitude H2-B of the negative direction external magnetic field H2 are set to be equal to each other at the timing the differential voltage becomes zero as illustrated in Fig. 11. If the differential voltage other than zero is set to be the threshold voltage, the magnitude of the external magnetic field causing the threshold voltage becomes different between the positive direction and the negative direction. For this reason, the zero differential voltage is preferably set to be the threshold voltage.

Also, for example, if the above-described ratios are different or the first interlayer coupling magnetic field Hin1 is different from the second interlayer coupling magnetic field Hin2 in magnitude (absolute value), the positive direction external magnetic field H1 and the negative direction external magnetic field H2 cannot be equal to each other with the differential voltage at zero. In order to output changing signals in response the positive direction external magnetic field and the negative direction external magnetic field of the same magnitude, different threshold voltages are preferably set for the positive direction external magnetic field H1 and the negative direction external magnetic field H2 in view of offsets.

The fixed resistance value X1 of the second magnetoresistance effect elements 12 and 13 with the external magnetic field H1 in the positive direction may fail to cross the hysteresis loop HR-A of the first magnetoresistance effect elements 10 and 11. The fixed resistance value X4 of the first magnetoresistance effect elements with the external magnetic field H2 in the negative direction may fail to cross the hysteresis loop HR-B of the second magnetoresistance effect elements 12 and 13. In such cases, the line of the differential voltage of zero cannot be set at the threshold voltage along the curves G and H denoted by a dot-and-dash chain line in Fig. 11 in accordance with the present embodiment. The threshold voltage needs to be adjusted in view of the offset amount from the zero differential voltage.

In accordance with the present embodiment on the other hand, the zero differential voltage set as the threshold voltage allows the magnitude H1-A of the positive direction external magnetic field H1 to be equal to the magnitude H2-B of the negative direction external magnetic field H2 as described above. The adjustment of the threshold voltage is easy, and the magnetoresistance effect elements thus reliably operate. In accordance with the present embodiment, with the positive direction external magnetic field H1 impinging on the magnet sensor 4 as illustrated in Figs. 1 and 2, the timing of outputting the on signal with the cellular phone illustrated in Fig. 1 and 2 opened (or the timing of outputting the off signal with the cellular phone closed) is synchronized with the timing of outputting the on signal with the cellular phone illustrated in Figs. 3 and 4 opened (or the timing of outputting the off signal with the cellular phone closed). In accordance with the present embodiment, the magnet sensor 4 operating reliably regardless of the difference in the polarity of the external magnetic field H is constructed of a simple circuit arrangement.

In accordance with the present embodiment, the fixed resistance value X1 is more preferably a median value between the minimum resistance value X2 and the maximum resistance value X3, and the fixed resistance value X4 is more preferably between the minimum resistance value X5 and the maximum resistance value X6. The external magnetic field in the positive direction and the external magnetic field in the negative direction are adjusted at a higher accuracy to be equal to each other when the on signal and the off signal are switched. The reliably operating bipolar operating magnet sensor 4 can thus be manufactured.

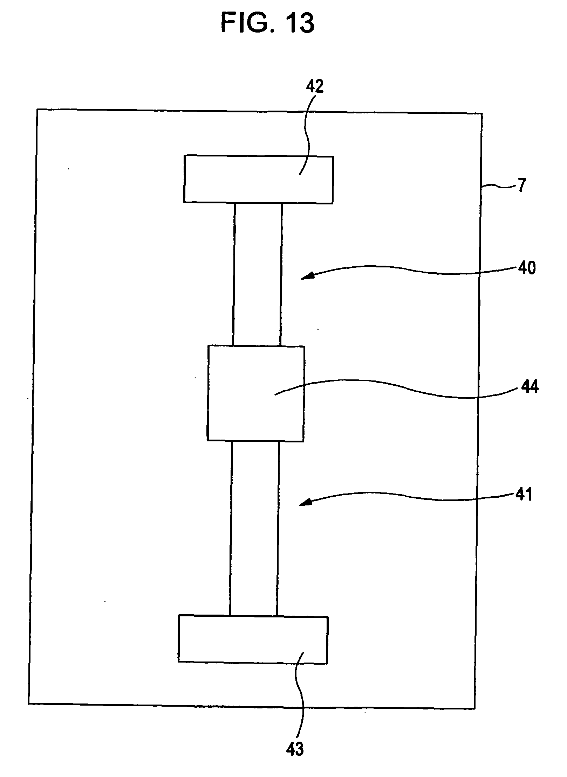

Fig. 13 is a plan view of a magnetic sensor different from the magnetic sensor illustrated in Figs. 5 and 6, and Fig. 14 is a circuit diagram of the magnetic sensor of Fig. 13.

Referring to Fig. 13, a first magnetoresistance effect element 40 and a second magnetoresistance effect element 41 are arranged. The first magnetoresistance effect element 40 is serially connected to the second magnetoresistance effect element 41. An input terminal 42 is connected to one end of the first magnetoresistance effect element 40 and a ground terminal 43 is connected to one end of the second magnetoresistance effect element 41. An output terminal 44 is connected to a junction between the first magnetoresistance effect element 40 and the second magnetoresistance effect element 41.

The first magnetoresistance effect element 40 has the hysteresis characteristics illustrated in Fig. 10A, and the second magnetoresistance effect element 41 has the hysteresis characteristics illustrated in Fig. 10B. The first magnetoresistance effect element 40 changes the resistance thereof in response to the magnetic field strength change of the external magnetic field H1 in the positive direction while the second magnetoresistance effect element 41 maintains a constant resistance value. The second magnetoresistance effect element 41 changes the resistance thereof in response to the magnetic field strength change of the external magnetic field H2 in the negative direction while the first magnetoresistance effect element 40 maintains a constant resistance. A bipolar operating magnetic sensor thus results. The magnet 5 causing the external magnetic field is free from installation restrictions in comparison with the magnet in the related art, and the assembling of the magnetic sensor is easy.

The first magnetoresistance effect element 40 and the second magnetoresistance effect element 41 are identical to the above-described bridge circuit in terms of preferred layer structure and hysteresis characteristics, and the previous discussion thereon should be referred to.

Specific numerical values of the elements are described below.

The length dimension L1 of each of the first magnetoresistance effect elements 10, 11, and 40 is about 1700 µm, the length dimension L2 of each of the second magnetoresistance effect elements 12, 13, and 41 is about 1700 µm, the thickness of the nonmagnetic intermediate layer 34 in each of the first magnetoresistance effect elements 10, 11, and 40 is within an approximate range of 19-23 µm, and the thickness of the nonmagnetic intermediate layer 34 of each of the second magnetoresistance effect elements 12, 13, and 41 is within an approximate range of 19-23 µm.

The conditions of the plasma treatment are a power value of 130 W, an Ar gas pressure of 45 mTorr (about 6 Pa), and a process time of about 60 seconds.

The above-described plasma treatment is performed on one magnetoresistance effect element so that the interlayer coupling magnetic field Hin is adjusted to be shifted in the negative direction. On the other hand, in the other magnetoresistance effect element, the thickness of the antiferromagnetic layer is adjusted to within an approximate range of 50-200 A so that an interlayer coupling magnetic field shifted in the positive direction is obtained. By adjusting the layer thickness of the antiferromagnetic layer, the surface state is changed and the interlayer coupling magnetic field is thus varied.

Also, the first interlayer coupling magnetic field Hin1 is within a approximate range of 7.5 through 10.5 Oe, the second interlayer coupling magnetic field Hin2 is within an approximate range of -17.5 through -7.5 Oe, and the magnitude of the external magnetic field in the range of use is within an approximate range of -100 through 100 Oe.

Also, as described above, the magnet sensor 4 of the present embodiment is used in the flip cellular phone 1. The magnet sensor 4 may be used as a opening detector or the like in a mobile electronic device such as a game playing device. The present embodiment may find applications in which the bipolar operative magnet sensor 4 is used for any purpose other than the opening detection.

Optionally, a bias magnetic field may be applied to the magnetoresistance effect element. It is not necessary that the bias magnetic field be applied to the free magnetic field forming the magnetoresistance effect element. If the bias magnetic field is applied at all, control is to be performed so that the magnetization state illustrated in Fig. 9 is established.

The magnetoresistance effect element here has a linear shape. However, the magnetoresistance effect element is not limited to any particular shape. For example, the magnetoresistance effect element may have a meandering shape.

Moreover, the "magnetic sensor" may be a combination of the magnet sensor 4 as a sensor unit and the magnet (external magnetic field generating means) 5 or only the magnet sensor 4 as a sensor unit.

### Brief Description of the Drawings

[Fig. 1] Fig. 1 is a partial diagrammatic view of a flip cellular phone (in a closed state) containing a magnetic sensor of a first embodiment with an external magnetic field H1 operating in a positive direction.
[Fig. 2] Fig. 2 is a partial diagrammatic view of the flip cellular phone (in an open state) containing the magnetic sensor of the first embodiment with the external magnetic field H1 operating in the positive direction.
[Fig. 3] Fig. 3 is a partial diagrammatic view of the flip cellular phone (in a closed state) containing the magnetic sensor of the first embodiment with an external magnetic field H2 operating in a negative direction.
[Fig. 4] Fig. 4 is a partial diagrammatic view of the flip cellular phone (in an open state) containing the magnetic sensor of the first embodiment with the external magnetic field H2 operating in the negative direction.
[Fig. 5] Fig. 5 is a partial plan view of the magnetic sensor of the present embodiment with the external magnetic field H1 operating in the positive direction.
[Fig. 6] Fig. 6 is a circuit diagram of the magnetic sensor illustrated in Fig. 5.
[Fig. 7] Fig. 7 is a partial plan view of the magnetic sensor of the present embodiment with the external magnetic field H2 operating in the negative direction.
[Fig. 8] Fig. 8 is a circuit diagram of the magnetic sensor illustrated in Fig. 7.
[Fig. 9] Fig. 9 is a partial sectional view of the magnetic sensor taken along line A-A and viewed from arrows in Fig. 5.
[Fig. 10] Fig. 10A is an R-H curve representing hysteresis characteristics of a first magnetoresistance effect element,
Fig. 10B is an R-H curve representing hysteresis characteristics of a second magnetoresistance effect element, and Fig. 10C is an R-H curve combining the hysteresis characteristics of Figs. 10A and 10B.
[Fig. 11] Fig. 11 is a graph representing a relationship between an external magnetic field H and a differential voltage.
[Fig. 12] Fig. 12 is a graph representing a relationship of a gas flow rate (gas pressure), a power value, and an interlayer coupling magnetic field Hin.
[Fig. 13] Fig. 13 is a partial sectional view of a magnetic sensor of a second embodiment.

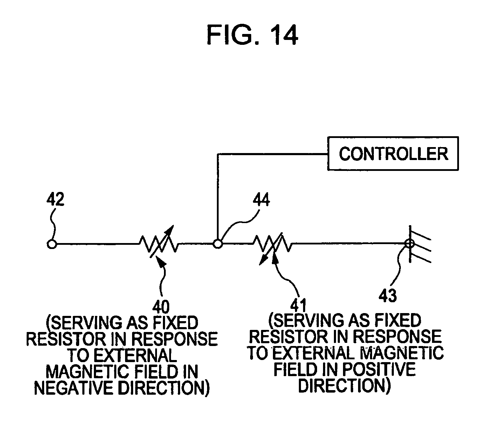

[Fig. 14] Fig. 14 is a circuit diagram of the magnetic sensor of Fig. 13.

### Reference Numerals

- 1: Flip cellular phone
- 2: First unit
- 3: Second unit
- 4: Magnetic sensor
- 5: Magnet
- 6: Circuit board
- 7: Element substrate
- 10, 11, and 40: First magnetoresistance effect elements
- 12, 13, and 41: Second magnetoresistance effect elements
- 14: First serial circuit
- 15: Second serial circuit
- 16 and 42: Input terminals
- 17 and 43: Ground terminals
- 18: First output terminal
- 19: Second output terminal
- 20: Operational amplifier
- 21: Controller
- 32: Antiferromagnetic layer
- 33: Fixed magnetic layer
- 34: Nonmagnetic intermediate layer
- 35 and 37: Free magnetic layers
- 44: Output terminal
- H: External magnetic field
- H1: Positive direction external magnetic field
- H2: Negative direction external magnetic field
- Hin1 and Hin2: Interlayer coupling magnetic fields
- HR-A and RH-B: Hysteresis loops

## Claims

1. A magnetic sensor comprising a series circuit (14, 15) that connects in a serial connection a first magnetoresistance effect element (10, 11; 40) and a second magnetoresistance effect element (12, 13; 41), each element being configured such that a resistance thereof changes in response to a change in a magnetic field strength of an external magnetic field (H1), and outputs a voltage at a junction (44) between the first magnetoresistance effect element (10, 11; 40) and the second magnetoresistance effect element (12, 13; 41),
wherein the first magnetoresistance effect element (10, 11; 40) is configured such that the resistance thereof changes in response to a change in the magnetic field strength in a positive direction (H1) of the external magnetic field (H) while the second magnetoresistance effect element(12, 13; 41) is configured to maintain a constant resistance value, the one direction of the external magnetic field (H) being the positive direction (H1) and the direction opposite to the one direction being a negative direction (H2), and
wherein the second magnetoresistance effect element(12, 13; 41) is configured such that the resistance thereof changes in response to a change in the magnetic field strength in the negative direction (H2) of the external magnetic field (H) while the first magnetoresistance effect element (10, 11; 40) is configured to maintain a constant resistance value,
wherein the first magnetoresistance effect element (10, 11; 40) and the second magnetoresistance effect element (12, 13; 41) are configured such that an increase and decrease trend in the resistance change of the first magnetoresistance effect element(10, 11; 40) in response to a change in the positive direction (H1) in the magnetic field strength and an increase and decrease trend in the resistance change of the second magnetoresistance effect element (12, 13; 41) in response to a change in the negative direction (H2) in the magnetic field strength are reversed with respect to a non-magnetic state of the external magnetic field (H),
**characterized in**
**that** a fixed resistance value X1 of the second magnetoresistance effect element (12, 13; 41) with the external magnetic field (H1) in the positive direction (H1) is larger than a minimum resistance value X2 of the first magnetoresistance effect element (10, 11; 40) changing in response to a change in the magnetic intensity in the positive direction (H1) and smaller than a maximum resistance value X3 of the first magnetoresistance effect element (10, 11; 40) changing in response to a change in the magnetic intensity in the positive direction (H1),
**that** a fixed resistance value X4 of the first magnetoresistance effect element (10, 11; 40) with the external magnetic field (H1) in the negative direction (H2) is larger than a minimum resistance value X5 of the second magnetoresistance effect element (41) changing in response to a change in the magnetic intensity in the negative direction (H2) and smaller than a maximum resistance value X6 of the second magnetoresistance effect element (12, 13; 41) changing in response to a change in the magnetic intensity in the negative direction (H2), and
**that** a ratio of (X1 - X2) / (X3 - X1) is
equal to a ratio of (X6 - X4) / (X4 - X5).

2. The magnetic sensor according to claim 1,
wherein the fixed resistance value X1 is a median value between the minimum resistance value X2 and the maximum resistance value X3, and the fixed resistance value X4 is a median value between the minimum resistance value X5 and the maximum resistance value X6.

3. The magnetic sensor according to one of claims 1 and 2,
wherein the first magnetoresistance effect element (10, 11; 40) and the second magnetoresistance effect element (12, 13; 41) have the same layer structure composed of an antiferromagnetic layer (32), a fixed magnetic layer (33), a nonmagnetic intermediate layer (34), and a free magnetic layer(35; 37),
wherein in an R-H curve with the abscissa thereof representing the external magnetic field (H) and the ordinate thereof representing the resistance value of the magnetoresistance effect element(10, 11, 12, 13; 40, 41), a first interlayer coupling magnetic field Hin1 acting on the fixed magnetic layer (33) and the free magnetic layer (35) of the first magnetoresistance effect element (10, 11; 40) is shifted in the positive direction (H1) of the external magnetic field (H), and a second interlayer coupling magnetic field Hin2 acting on the fixed magnetic layer (33) and the free magnetic layer (37) of the second magnetoresistance effect element (12, 13; 41) is shifted in the negative direction (H2) of the external magnetic field (H).

4. The magnetic sensor according to claim 3,
wherein the first interlayer coupling magnetic field Hin1 and the second interlayer coupling magnetic field Hin2 have the same magnitude in the absolute value.

5. The magnetic sensor according to one of claims 3 and 4,
wherein the magnetization of the fixed magnetic layer and the magnetization of the free magnetic layer in one of the first magnetoresistance effect element (10, 11; 40) and the second magnetoresistance effect element (12, 13; 41) are in the same direction in the non-magnetic state of the external magnetic field, the magnetization of the fixed magnetic layer and the magnetization of the free magnetic layer in the other of the first magnetoresistance effect element (10, 11; 40) and the second magnetoresistance effect element (12, 13; 41) are anti-parallel to each other, and the magnetization of the fixed magnetic layer of the first magnetoresistance effect element (10, 11; 40) and the magnetization of fixed magnetic layer of the second magnetoresistance effect element (12, 13; 41) are aligned in the same direction.

6. The magnetic sensor according to one of claims 1 through 5,
wherein two first magnetoresistance effect elements (10, 11) and two second magnetoresistance effect elements (12, 13) are arranged, a first serial circuit (14) is formed of one of the first magnetoresistance effect elements (10) and one of the second magnetoresistance effect elements (12), and a second serial circuit (15) is formed of the remaining first magnetoresistance effect element (11) and the remaining second magnetoresistance effect element (13),
wherein the first magnetoresistance effect element (10) in the first serial circuit (14) and the second magnetoresistance effect element (13) in the second serial circuit (15) are connected in parallel and the second magnetoresistance effect element (12) in the first serial circuit (14) and the first magnetoresistance effect element (11) in the second serial circuit (15) are connected in parallel, and
wherein a difference between a voltage at a junction (18) of the first serial circuit (14) and a voltage at a junction (19) of the second serial circuit (15) is output as a differential voltage.

## Patentansprüche

1. Magnetsensor aufweisend eine Serienschaltung (14, 15), die in einer seriellen Verbindung ein erstes Magnetwiderstandseffektelement (10, 11; 40) und ein zweites Magnetwiderstandseffektelement (12, 13; 41) verschaltet, wobei jedes Element derart konfiguriert ist, dass sich sein Widerstand sich in Reaktion auf eine Änderung bei einer Magnetfeldstärke eines externen Magnetfelds (H1) ändert, und eine Spannung an einer Verbindungsstelle (44) zwischen dem ersten Magnetwiderstandseffektelement (10, 11; 40) und dem zweiten Magnetwiderstandseffektelement (12, 13; 41) ausgibt,
wobei das erste Magnetwiderstandseffektelement (10, 11; 40) derart konfiguriert ist, dass sein Widerstand sich in Reaktion auf eine Änderung bei der Magnetfeldstärke in eine positive Richtung (H1) des externen Magnetfelds (H) ändert, während das zweite Magnetwiderstandseffektelement (12, 13; 41) konfiguriert ist, einen Konstantwiderstandswert beizubehalten, wobei die eine Richtung des externen Magnetfelds (H) die positive Richtung (H1) ist und die Richtung entgegengesetzt zu der einen Richtung eine negative Richtung (H2) ist, und
wobei das zweite Magnetwiderstandseffektelement (12, 13; 41) derart konfiguriert ist, dass sein Widerstand sich in Reaktion auf eine Änderung bei der Magnetfeldstärke in der negativen Richtung (H2) des externen Magnetfelds (H) ändert, während das erste Magnetwiderstandseffektelement (10, 11; 40) konfiguriert ist, einen Konstantwiderstandswert beizubehalten,
wobei das erste Magnetwiderstandseffektelement (10, 11; 40) und das zweite Magnetwiderstandseffektelement (12, 13; 41) derart konfiguriert sind, dass ein Erhöhungs- und ein Verringerungstrend bei der Widerstandsänderung des ersten Magnetwiderstandseffektelements (10, 11; 40) in Reaktion auf eine Änderung in der positiven Richtung (H1) bei der Magnetfeldstärke und ein Erhöhungs- und Verringerungstrend bei der Widerstandsänderung des zweiten Magnetwiderstandseffektelements (12, 13; 41) in Reaktion auf eine Änderung in der negativen Richtung (H2) bei der Magnetfeldstärke mit Bezug auf einen nicht-magnetischen Zustand des externen Magnetfelds (H) umgekehrt sind,
**dadurch gekennzeichnet,**
**dass** ein Festwiderstandswert X1 des zweiten Magnetwiderstandseffektelements (12, 13; 41), mit dem externen Magnetfeld (H) in der positiven Richtung (H1), größer ist als ein Minimumwiderstandswert X2 des ersten Magnetwiderstandseffektelements (10, 11; 40), welcher sich in Reaktion auf eine Änderung bei der magnetischen Intensität in der positiven Richtung (H1) ändert, und kleiner ist als ein Minimumwiderstandswert X3 des ersten Magnetwiderstandseffektelements (10, 11; 40), welcher sich in Reaktion auf eine Änderung bei der magnetischen Intensität in die positive Richtung (H1) ändert,
**dass** ein Festwiderstandswert X4 des ersten Magnetwiderstandseffektelements (10, 11; 40), mit dem externen Magnetfeld (H1) in der negativen Richtung (H2), größer ist als ein Minimumwiderstandswert X5 des zweiten Magnetwiderstandseffektelements (41), welcher sich in Reaktion auf eine Änderung bei der magnetischen Intensität in die negative Richtung (H2) ändert, und kleiner ist als ein Minimumwiderstandswert X6 des zweien Magnetwiderstandseffektelements (12, 13; 41), welcher sich in Reaktion auf eine Änderung bei der magnetischen Intensität in die negative Richtung (H2) ändert, und
**dass** ein Verhältnis (X1-X2)/(X3-X1)
gleich einem Verhältnis (X6-X4)/(X4-X5) ist.

2. Magnetsensor gemäß Anspruch 1,
wobei der Festwiderstandswert X1 ein Medianwert zwischen dem Minimumwiderstandswert X2 und dem Maximumwiderstandswert X3 ist, und wobei der Festwiderstandswert X4 in Medianwert zwischen dem Minimumwiderstandswert X5 und dem Maximumwiderstandswert X6 ist.

3. Magnetsensor gemäß einem der Ansprüche 1 und 2,
wobei das erste Magnetwiderstandseffektelement (10, 11; 40) und das zweite Magnetwiderstandseffektelement (12, 13; 41) denselben Schichtaufbau aufweisen, der aus einer antiferromagnetischen Schicht (32), einer Festmagnetschicht (33), einer nicht-magnetischen Zwischenschicht (34) und einer freien magnetischen Schicht (35; 37) zusammengesetzt ist,
wobei in einer R-H-Kurve, deren Abszisse das externe Magnetfeld H repräsentiert und deren Ordinate den Widerstandswert des Magnetwiderstandseffektelements (10, 11, 12; 13; 40, 41) repräsentiert, ein erstes Zwischenschichtkoppelmagnetfeld Hin1, welches auf die Festmagnetschicht (33) und die Freimagnetschicht (35) des ersten Magnetwiderstandseffektelements (10, 11; 40) wirkt, in die positive Richtung (H1) des externen Magnetfelds (H) verschoben ist, und ein zweites Zwischenschichtkoppelmagnetfeld Hin2, welches auf die erste Festmagnetschicht (33) und die Freimagnetschicht (37) des zweiten Magnetwiderstandseffektelements (12, 13; 41) wirkt, in die negative Richtung (H2) des externen Magnetfelds (H) verschoben ist.

4. Magnetsensor gemäß Anspruch 3,
wobei das erste Zwischenschichtkoppelmagnetfeld Hin1 und das zweite Zwischenschichtkoppelmagnetfeld Hin2 denselben Absolutwert aufweisen.

5. Magnetsensor gemäß einem der Ansprüche 3 und 4,
wobei die Magnetisierung der Festmagnetschicht und die Magnetisierung der freien Magnetschicht bei einem von dem ersten Magnetwiderstandseffektelement (10, 11; 40) und dem zweiten Magnetwiderstandseffektelement (12, 13; 41) im nicht-magnetischen Zustand des externen Magnetfelds in dieselbe Richtung weisen, wobei die Magnetisierung der Festmagnetschicht und die Magnetisierung der freien Magnetschicht in dem anderen von dem ersten Magnetwiderstandseffektelement (10, 11; 40) und dem zweiten Magnetwiderstandseffektelement (12, 13; 41) antiparallel zueinander sind, und wobei die Magnetisierung der Festmagnetschicht des ersten Magnetwiderstandseffektelements (10, 11; 40) und die Magnetisierung der Festmagnetschicht des zweiten Magnetwiderstandseffektelements (12, 13; 41) in dieselbe Richtung ausgerichtet sind.

6. Magnetsensor gemäß einem der Ansprüche 1 bis 5,
wobei zwei erste Magnetwiderstandseffektelemente (10, 11) und zwei zweite Magnetwiderstandseffektelemente (12, 13) angeordnet sind, wobei eine erste Serienschaltung (14) zu seinem der ersten Magnetwiderstandseffektelemente (10) und einem der zweiten Magnetwiderstandseffektelemente (12) gebildet ist, und eine zweite Serienschaltung (15) aus dem verbleibenden ersten Magnetwiderstandseffektelement (11) und dem verbleibenden zweiten Magnetwiderstandseffektelement (13) gebildet ist,
wobei das erste Magnetwiderstandseffektelement (10) in der ersten Serienschaltung (14) und das zweite Magnetwiderstandseffektelement (13) in der zweiten Serienschaltung (15) parallel zueinander geschaltet sind und das zweite Magnetwiderstandseffektelement (12) in der ersten Serienschaltung (14) und das erste Magnetwiderstandseffektelement (11) in der zweiten Serienschaltung (15) parallel geschaltet sind, und
wobei eine Differenz zwischen einer Spannung an einer Verbindungsstelle (18) der ersten Serienschaltung (14) und eine Spannung an einer Verbindungsstelle (19) der zweiten Serienschaltung (15) als eine differenzielle Spannung ausgegeben wird.

## Revendications

1. Capteur magnétique comprenant un circuit série (14, 15) qui connecte en une connexion série un premier élément à effet de magnétorésistance (10, 11 ; 40) et un deuxième élément à effet de magnétorésistance (12, 13 ; 41), chaque élément étant configuré de telle manière qu'une résistance de celui-ci change en réponse à un changement d'intensité de champ magnétique d'un champ magnétique extérieur (H1), et délivre une tension au niveau d'une jonction (44) entre le premier élément à effet de magnétorésistance (10, 11 ; 40) et le deuxième élément à effet de magnétorésistance (12, 13 ; 41),
dans lequel le premier élément à effet de magnétorésistance (10, 11 ; 40) est configuré de telle manière que la résistance de celui-ci change en réponse à un changement de l'intensité de champ magnétique dans une direction positive (H1) du champ magnétique extérieur (H) tandis que le deuxième élément à effet de magnétorésistance (12, 13 ; 41) est configuré pour maintenir une valeur de résistance constante, la première direction du champ magnétique extérieur (H) étant la direction positive (H1) et la direction contraire à la première direction étant une direction négative (H2), et
dans lequel le deuxième élément à effet de magnétorésistance (12, 13 ; 41) est configuré de telle manière que la résistance de celui-ci change en réponse à un changement de l'intensité de champ magnétique dans la direction négative (H2) du champ magnétique extérieur (H) tandis que le premier élément à effet de magnétorésistance (10, 11 ; 40) est configuré pour maintenir une valeur de résistance constante,
dans lequel le premier élément à effet de magnétorésistance (10, 11 ; 40) et le deuxième élément à effet de magnétorésistance (12, 13 ; 41) sont configurés de telle manière qu'une tendance à la montée et à la descente de la variation de résistance du premier élément à effet de magnétorésistance (10, 11 ; 40) en réponse à un changement de la direction positive (H1) de l'intensité de champ magnétique et une tendance à la montée et à la descente de la variation de résistance du deuxième élément à effet de magnétorésistance (12, 13 ; 41) en réponse à un changement de la direction négative (H2) de l'intensité de champ magnétique sont inversées par rapport à un état non magnétique du champ magnétique extérieur (H),
**caractérisé**
**en ce qu'**une valeur de résistance fixe X1 du deuxième élément à effet de magnétorésistance (12, 13 ; 41) avec le champ magnétique extérieur (H1) dans la direction positive (H1) est supérieure à une valeur de résistance minimum X2 du premier élément à effet de magnétorésistance (10, 11 ; 40) variant en réponse à un changement de l'intensité magnétique dans la direction positive (H1) et inférieure à une valeur de résistance maximum X3 du premier élément à effet de magnétorésistance (10, 11 ; 40) variant en réponse à un changement de l'intensité magnétique dans la direction positive (H1),
**en ce qu'**une valeur de résistance fixe X4 du premier élément à effet de magnétorésistance (10, 11 ; 40) avec le champ magnétique extérieur (H1) dans la direction négative (H2) est supérieure à une valeur de résistance minimum X5 du deuxième élément à effet de magnétorésistance (41) variant en réponse à un changement de l'intensité magnétique dans la direction négative (H2) et inférieure à une valeur de résistance maximum X6 du deuxième élément à effet de magnétorésistance (12, 13 ; 41) variant en réponse à un changement de l'intensité magnétique dans la direction négative (H2), et
**en ce que** le rapport (X1-X2)/(X3-X1) est égal au rapport (X6-X4)/(X4-X5).

2. Capteur magnétique selon la revendication 1, dans lequel la valeur de résistance fixe X1 est une valeur médiane entre la valeur de résistance minimum X2 et la valeur de résistance maximum X3, et la valeur de résistance fixe X4 est une valeur médiane entre la valeur de résistance minimum X5 et la valeur de résistance maximum X6.

3. Capteur magnétique selon l'une des revendications 1 et 2, dans lequel le premier élément à effet de magnétorésistance (10, 11 ; 40) et le deuxième élément à effet de magnétorésistance (12, 13 ; 41) ont la même structure de couche composée d'une couche antiferromagnétique (32), d'une couche magnétique fixe (33), d'une couche intermédiaire non magnétique (34) et d'une couche magnétique libre (35 ; 37),
dans lequel une courbe R-H dont l'abscisse représente le champ magnétique extérieur (H) et dont l'ordonnée représente la valeur de résistance de l'élément à effet de magnétorésistance (10, 11, 12, 13 ; 40, 41), un premier champ magnétique de couplage intercouche Hin1 agissant sur la couche magnétique fixe (33) et la couche magnétique libre (35) du premier élément à effet de magnétorésistance (10, 11 ; 40) est décalé dans la direction positive (H1) du champ magnétique extérieur (H), et un deuxième champ magnétique de couplage intercouche Hin2 agissant sur la couche magnétique fixe (33) et la couche magnétique libre (37) du deuxième élément à effet de magnétorésistance (12, 13 ; 41) est décalé dans la direction négative (H2) du champ magnétique extérieur (H).

4. Capteur magnétique selon la revendication 3, dans lequel le premier champ magnétique de couplage intercouche Hin1 et le deuxième champ magnétique de couplage intercouche Hin2 ont la même amplitude en valeur absolue.

5. Capteur magnétique selon l'une des revendications 3 et 4, dans lequel la magnétisation de la couche magnétique fixe et la magnétisation de la couche magnétique libre dans l'un des premier élément à effet de magnétorésistance (10, 11 ; 40) et deuxième élément à effet de magnétorésistance (12, 13 ; 41) sont dans la même direction dans l'état non magnétique du champ magnétique extérieur, la magnétisation de la couche magnétique fixe et la magnétisation de la couche magnétique libre dans l'autre des premier élément à effet de magnétorésistance (10, 11 ; 40) et deuxième élément à effet de magnétorésistance (12, 13 ; 41) sont antiparallèles entre elles, et la magnétisation de la couche magnétique fixe du premier élément à effet de magnétorésistance (10, 11 ; 40) et la magnétisation de la couche magnétique fixe du deuxième élément à effet de magnétorésistance (12, 13 ; 41) sont alignées dans la même direction.

6. Capteur magnétique selon l'une des revendications 1 à 5,
dans lequel deux premiers éléments à effet de magnétorésistance (10, 11) et deux deuxièmes éléments à effet de magnétorésistance (12, 13) sont disposés, un premier circuit série (14) est formé de l'un des premiers éléments à effet de magnétorésistance (10) et de l'un des deuxièmes éléments à effet de magnétorésistance (12), et un deuxième circuit série (15) est formé du premier élément à effet de magnétorésistance restant (11) et du deuxième élément à effet de magnétorésistance restant (13),
dans lequel le premier élément à effet de magnétorésistance (10) du premier circuit série (14) et le deuxième élément à effet de magnétorésistance (13) du deuxième circuit série (15) sont connectés en parallèle et le deuxième élément à effet de magnétorésistance (12) du premier circuit série (14) et le premier élément à effet de magnétorésistance (11) du deuxième circuit série (15) sont connectés en parallèle, et
dans lequel une différence entre une tension au niveau d'un jonction (18) du premier circuit série (14) et une tension au niveau d'une jonction (19) du deuxième circuit série (15) est délivrée en tant que tension différentielle.
